# EUROPÄISCHE PATENTSCHRIFT

(11) **EP 3 680 692 B1**
(45) Veröffentlichungstag und Bekanntmachung des Hinweises auf die Patenterteilung: **21.06.2023**
(21) Anmeldenummer: 19206806.2
(22) Anmeldetag: 04.11.2019
(51) Int. Cl.: G01V 3/08, E05F 15/46, H03K 17/955

(54) **KAPAZITIVES SENSORSYSTEM**
CAPACITIVE SENSOR SYSTEM
SYSTÈME DE CAPTEUR CAPACITIF

(30) Priorität: 11.01.2019 DE 102019200299
(43) Veröffentlichungstag der Anmeldung: 15.07.2020
(73) Patentinhaber: Robert Bosch GmbH, 70442 Stuttgart (DE)
(72) Erfinder: Bonemberg, Adam, 70195 Stuttgart (DE); Fischer, Chris, 70435 Stuttgart (DE); Bauer, Raphael, 72669 Unterensingen (DE); Niess, Rainer, 73269 Hochdorf (DE)

(56) Entgegenhaltungen:
- JP-A- 2017 150 881
- US-A1- 2006 071 624
- US-A1- 2010 079 269
- US-A1- 2013 271 157
- US-A1- 2018 238 096
- US-B2- 7 044 271

## Beschreibung

Die vorliegende Erfindung betrifft ein Sensorsystem zur Umfeldüberwachung nach dem Oberbegriff des Anspruchs 1 sowie ein Tor oder Fenster oder eine Tür mit einem Sensorsystem nach Anspruch 10.

Ein bekanntes Sensorsystem zur Umfeldüberwachung hat mindestens zwei kapazitive Sensoren, die jeweils zumindest eine Sensorelektrode aufweisen. Die Sensorelektroden sind zur kapazitiven Umfeldmessung eingerichtet. Dabei weist jeder Sensor einen Detektionsbereich auf, innerhalb dessen eine kapazitiv wirksame Veränderung des Umfeldes detektierbar ist. Die zumindest zwei Sensoren gemeinsam decken dabei einen resultierenden Überwachungsbereich ab, wenn sie gemeinsam ausgewertet werden.

Mit der Anzahl der Sensoren steigt die Komplexität des Sensorsystems an, wodurch insbesondere auch Übergangsprobleme bei den Übergangszonen zwischen den Sensoren sich nachteilig auswirken, insbesondere auch bei sicherheitsrelevanten Anwendungen.

US 2013/271157 A1 offenbart eine Näherungsschalterbaugruppe und ein Verfahren zum Erkennen der Aktivierung einer Näherungsschalterbaugruppe. Die Anordnung umfasst eine Vielzahl von Näherungsschaltern, von denen jeder einen Näherungssensor aufweist, der ein Erfassungsaktivierungsfeld bereitstellt, und eine Steuerschaltung, die das Aktivierungsfeld jedes Näherungsschalters verarbeitet, um die Aktivierung zu erfassen. Die Steuerschaltung überwacht das auf das Aktivierungsfeld reagierende Signal und bestimmt eine differentielle Änderung des erzeugten Signals und erzeugt einen Aktivierungsausgang, wenn das differentielle Signal einen Schwellenwert überschreitet. Der Steuerschaltkreis unterscheidet ferner eine Aktivierung von einer Erkundung der Vielzahl von Schaltern und kann eine Aktivierung bei Erkennung eines stabilen Signals feststellen.

JP 2017 150881 A offenbart die Bereitstellung eines einfach aufgebauten Objektsensors, der berührungslos den Anwesenheitsbereich eines in der Nähe befindlichen Objekts detektiert. Drei Längen von linearen Elektroden E1-E3 sind auf einer Detektionsebene auf einem ebenen Träger 30 nebeneinander angeordnet und zum Schutz mit einer Isolierschicht 40 bedeckt. Die Erfassungsbereiche Aleft, Aright sind links und rechts einer Anordnungslinie Lx2 der linearen Elektrode E2 in der Mitte als Grenzlinie B definiert. Ein kapazitives Element C1 wird durch die Elektroden E1, E2 gebildet, und ein kapazitives Element C2 wird durch die Elektroden E2, E3 gebildet. Es wird eine Differenz der elektrostatischen Kapazität zwischen dem kapazitiven Element C1 und dem kapazitiven Element C2 berechnet.

US 7044271 B2 offenbart einen Sicherheitsmechanismus für Aufzugsanlagen mit einer Aufzugskabine, die in einem Aufzugsschacht verschiebbar ist. Die Zugänge zum Aufzugsschacht und zur Aufzugskabine weisen jeweils mindestens eine Schiebetür auf, die durch einen vorzugsweise an der Aufzugskabine angeordneten Antriebsmechanismus automatisch betätigbar ist. An jeder Schiebetür ist mindestens eine Detektoreinrichtung vorgesehen, die im Bereich einer Quetschkante zwischen einer Schiebetür und einem Türpfosten und/oder zwischen zwei benachbarten Schiebetürflügeln angeordnet ist. Je nach erkanntem Zustand der überwachten Bereiche erzeugt die Detektoreinrichtung ein Türfreigabesignal oder sorgt für die Unterbrechung des Antriebsmechanismus zum Öffnen der Schiebetür. Die Signale der Detektoreinrichtungen an den Schiebetüren des Aufzugsschachtes können in Abhängigkeit von der Position der Aufzugskabine empfangen werden. In diesem Fall können nur die Signale der Detektoreinrichtung an der Schiebetür des Aufzugsschachtes berücksichtigt werden, die als nächstes zusammen mit der Schiebetür der Aufzugskabine automatisch geöffnet werden soll.

Es ist daher Aufgabe der Erfindung, ein Sensorsystem der eingangs genannten Art bereitzustellen, das weitgehend räumlich durchgängig ein hohes Maß an Einfachheit und Konstanz bei der Messgenauigkeit bzw. bei der Erkennungsgenauigkeit bietet. Insbesondere wird bei einem Sensorsystem mit mehreren Sensoren eine reproduzierbarere, deterministischere und verlässlichere Ausgabe gewährleistet. Gleichzeitig kann die Reichweite und/oder die Empfindlichkeit und/oder die Reproduzierbarkeit der Ergebnisse eines Sensorsystems erhöht werden, sodass es insbesondere für eine bedarfsmäßig angepasste Reaktion befähigt und/oder sehr flexibel einsetzbar und konfigurierbar ist. Schließlich soll auch eine inhärent/natürlich sicherheitskongruente Geometrie und/oder ein inhärent sicherheitsgerichteter Überwachungsraum dargestellt werden.

Diese Aufgaben werden vollständig oder teilweise gelöst durch ein Sensorsystem nach Anspruch 1.

Die Erfindung bietet den Vorteil, dass sie die negativen Effekte von Übergangsproblemen zwischen benachbarten Sensoren einer Sensoranordnung minimiert bis komplett eliminiert, so dass eine inhärent sicherheitskongruente Geometrie und ein natürlicherweise und inhärent sicherheitsgerichteter Überwachungsraum bereitgestellt werden können. Dabei verhält sich ein erfindungsgemäßes Sensorsystem mit einer Mehrzahl bis Vielzahl von Sensoren hinsichtlich der positiven Eigenschaften wie etwa Reichweite, Dynamik, Sicherheit, Schnelligkeit, mechanisch einfacher Aufbau, Empfindlichkeit, Flexibilität, Einstellbarkeit, flexible Konfigurierbarkeit, Sicherheit, Kosteneffizienz, Konstanz, Reproduzierbarkeit, Verlässlichkeit und Spezifität sehr gut, ohne oder mit nur geringer bis minimaler Auswirkung der üblicherweise mit einer Mehrzahl bis Vielzahl von Sensoren einhergehenden Probleme, insbesondere Übergangsprobleme. Insofern hat die Erfindung erkannt, dass alle oben genannten Vorteile der Verwendung von zumindest zwei Sensoren - gegenüber der Verwendung lediglich eines Sensors - unter Wahrung der Vorteile bei lediglich einem Sensor und/oder unter Vermeidung oder weitgehender Verringerung der Nachteile der Anordnung einer Mehrzahl bis Vielzahl von Sensoren erreichbar sind. Schließlich ist eine erfindungsgemäße Sensoranordnung inhärent mit den Anforderungen heutiger Sicherheitsstandards standardkonform auslegbar, und das bei verbesserten Leistungsdaten, verringerter Komplexität, verringerten Kosten und bei zusätzlichen Freiheitsgraden oder Funktionalitäten, wie etwa die Möglichkeit der Erfassung einer Lage, eine höhere Spezifität bei der Erkennung und/oder die Möglichkeit einer bedarfsmäßig angepassten Reaktion auf ein erkanntes Objekt/einen erkannten Körper.

Diese Vorteile erreicht die Erfindung unter anderem dadurch, dass die zumindest zwei kapazitiven Sensoren so implementiert sind, dass die Detektionsbereiche benachbarter Sensoren sich lokal überschneiden und/oder unmittelbar benachbart sind. Dadurch ist der resultierende Überwachungsbereich solchermaßen angeordneter, benachbarter Sensoren zusammenhängend. Gleichzeitig hat die Erfindung erkannt, dass ein solcher, zusammenhängender Überwachungsbereich vorteilhaft auf jegliche überwachte, vorbestimmte Sicherheitsgeometrie appliziert werden kann, wenn der zusammenhängende Überwachungsbereich zumindest einen Teil einer solchen - insbesondere vollständig - überwachten Sicherheitsgeometrie bildet. Damit wird die zu überwachende, vorbestimmte Sicherheitsgeometrie durch einen zusammenhängenden (insbesondere lückenlosen) Überwachungsbereich von simultan aktiven Sensoren mittels der zielgerichteten Anordnung von deren Detektionsbereichen vollständig und insbesondere auch sicherheitsgerichtet abdeckbar.

Ein erfindungsgemäß verwendeter, kapazitiver Sensor arbeitet dabei insbesondere nach dem Prinzip der Messung einer sich ändernden Kapazität oder von davon abhängigen Größen. Dazu sind im Prinzip zwei Elektroden vorhanden; eine der Elektroden kann dabei eine zu messende Oberfläche eines zu detektierenden Körpers oder eines Objektes sein; dann kann es sich um einen Sensor mit lediglich einer Elektrode handeln, wobei die andere Elektrode durch den Körper oder das Objekt gebildet wird (die andere Elektrode bzw. der Körper oder das Objekt sind dann vorzugsweise geerdet bzw. eine Erdelektrode GND (ground)).

Besonders bevorzugt ist es aber, wenn der Sensor aus einer Senderelektrode und einer Empfangselektrode besteht. Die Kapazität zwischen den Elektroden wird dann etwa durch Eindringen in den Detektionsbereich oder Verschiebung des Körpers oder Objektes verändert. Dies ist auch abhängig von der Zusammensetzung, vor allem von dem Material und der Leitfähigkeit des Körpers oder Objektes. Dadurch können praktisch eine Vielzahl von Formen und Zusammensetzungen sowie Größenordnungen von Objekten prinzipiell detektiert werden. Die Messverfahren bei solchen kapazitiven Sensoren sind bekannt und können etwa auf dem Prinzip eines Ladungsverstärkers beruhen, der bei anliegender Gleichspannung durch die Veränderung der Kapazität verschobene Ladungen misst; oder es können amplitudenmodulierte Systeme vorgesehen sein, wobei die Meßelektrode oder eine der Meßelektroden mit hochfrequentem Wechselstrom beaufschlagt und ein resultierender Blindstrom gemessen wird; oder frequenzmodulierte Systeme, wo zumindest ein Meßkondensator, entsprechend etwa einer Elektrode, mit einer Induktivität zu einem Schwingkreis zusammengeschaltet, dessen Frequenz gemessen und mit einer Referenz verglichen wird oder ein stabiler Multivibrator verwendet wird. Daneben sind noch viele andere Messverfahren für kapazitive Sensoren bekannt, die mittels der Erfindung die erfindungsgemäßen Vorteile erreichen.

Ein solcher, kapazitiver Sensor hat zumindest eine Sensorelektrode oder zwei oder noch mehr Sensorelektroden (beispielsweise zusätzliche Elektroden, wie eine Schirmelektrode, die einen möglicherweise inhomogenen Randbereich eines elektrischen Feldes abschirmt). Durch die Anordnung der Sensorelektrode(n) des jeweiligen Sensors ergibt sich ein Detektionsbereich für jeden Sensor. Erfindungsgemäß überschneiden sich Detektionsbereiche benachbarter Sensoren zumindest lokal und/oder sind unmittelbar benachbart. Das kann bedeuten, dass durch das messbare elektrische Feld - etwa veranschaulicht durch die zugehörigen Feldlinien - erfasste Raumbereiche unmittelbar aneinander angrenzen und/oder sich überschneiden. Wenn die entsprechenden Bereiche unmittelbar aneinander angrenzen kann dies beinhalten, dass im Übergangsbereich der Detektionsbereiche zweier benachbarter Sensoren das messbare elektrische Feld des einen Sensors ohne wirksamen Abstand bzw. ohne wirksame Lücke in das messbare elektrische Feld des anderen, benachbarten Sensors übergeht. Wenn die entsprechenden Bereiche sich - zumindest lokal - überschneiden oder überlappen, kann das bedeuten, dass im Übergangsbereich der Detektionsbereiche zweier benachbarter Sensoren sowohl das elektrische Feld des einen Sensors als auch das elektrische Feld des anderen, benachbarten Sensors messbar ist. Im obigen Sinne kann das elektrische Feld durch andere, entsprechende oder ähnliche physikalische Größen oder Prinzipien ersetzt werden, wie beispielsweise die resultierende, wirksame Kapazität oder die resultierende, wirksame Meßempfindlichkeit für lokale kapazitiv wirksame Einwirkungen oder durch das Modell der Feldlinien.

Im Ergebnis ist der sich durch die Zusammenfassung benachbarter Detektionsbereiche ergebende, simultane Überwachungsbereich zweier Sensoren praktisch zusammenhängend, so dass insbesondere etwaige Lücken des Überwachungsbereiches bezüglich der Detektion bzw. Empfindlichkeit der Sensoren indifferent oder vernachlässigbar sind. Der resultierende Überwachungsbereich ist insoweit praktisch oder im Endeffekt zusammenhängend; er muss nicht zwingend absolut streng zusammenhängend sein, da einzelne Lücken oder unzusammenhängende Stellen erfindungsgemäß vernachlässigbar werden. Zusammenhängend kann dabei neben dem oben Ausgeführten im engeren Sinne umfassen, dass die Detektionsbereiche benachbarter Sensoren zumindest in einem Punkt, im Bereich einer Grenzfläche und/oder im Bereich einer Trennfuge aneinander angrenzen oder in einem gemeinsam überdeckten Raumbereich - etwa in einer räumlichen Überschneidung der benachbarten Detektionsbereiche - überlappen.

Die Erfindung hat erkannt, dass sich eine solchermaßen zusammenhängende Überwachung hervorragend eignet, die Anforderungen einer sicherheitsgerichteten Überwachung einer vorbestimmten - insbesondere vollständig - überwachten Geometrie (Sicherheitsgeometrie) natürlich zu erfüllen. Dazu wird der vorgenannte, zusammenhängende Überwachungsbereich zumindest teilweise auf eine Sicherheitsgeometrie angewendet bzw. abgebildet. Im Bereich dieser Anwendung bzw. Abbildung ist die zu überwachende Sicherheitsgeometrie damit inhärent sicher zu überwachen. Der Überwachungsbereich bildet gleichermaßen ein sicherheitsrelevantes Teilstück der oder die gesamte Sicherheitsgeometrie ab. Dabei ist durch die besondere, erfindungsgemäß gegebene Flexibilität der Anordnung und inhärent sichere Überwachung praktisch jede Sicherheitsgeometrie abdeckbar. Eine solche Sicherheitsgeometrie kann beispielsweise eine lineare, flächige oder auch räumliche Form aufweisen. Sie wird in der Regel (etwa bei linearen oder flächigen Grundrissen einer zu überwachenden Struktur) durch den von einer Elektrode in den Raum ausgreifenden Detektionsbereich zu einer räumlichen Sicherheitsgeometrie mit einem charakteristischen Verlauf. Bei einer linearen Sicherheitsgeometrie werden die zusammenhängenden Detektionsbereiche zu einem linearen, in Richtung der linearen Sicherheitsgeometrie fortgesetzten, Geometrieschlauch oder Geometriezylinder, gegebenenfalls mit entlang dem Linienverlauf möglichst homogener oder leicht variierender Querausdehnung; dies entspricht dann im Wesentlichen der Form des resultierenden, zusammenhängenden Überwachungsbereichs. Entsprechendes gilt sinngemäß für eine im wesentlichen flächige Sicherheitsgeometrie. Auf Eigenschaften der Sicherheitsgeometrie wird weiter unten noch näher eingegangen.

Die Sicherheitsgeometrie ist erfindungsgemäß - insbesondere sicher und/oder vollständig - überwacht. Die Anzahl und/oder Anordnung von Sensoren kann verringert bzw. vereinfacht werden, indem einzelne Elektroden oder Sensoren gleichzeitig aktiviert/angesteuert/ausgewertet werden oder in einer vorgegebenen, zeitlichen Abfolge. Auch hierauf wird weiter unten noch näher eingegangen.

Insgesamt bevorzugt ist eine lineare Aneinanderreihung von Sensoren (mit entsprechender Überschneidung oder unmittelbarer Abfolge der Detektionsbereiche), so dass sich etwa ein Längsprofil der resultierenden Sensoranordnung ergibt. Diese kann als zusammenhängendes Längsprofil der Überwachung einer entsprechenden Längskante (wie z.B. einer Abschluss- oder Schließkante eines Tores oder einer Tür) dienen. Die geometrische Ausgestaltung wird weitere unten noch näher erläutert.

Die Erfindung wird anhand der Unteransprüche näher konkretisiert, die den Erfindungsgedanken nicht einschränken; alle Ansprüche/Unteransprüche sind in beliebiger Menge oder Reihenfolge miteinander kombinierbar.

Mechanisch einfach und trotzdem effektiv kann eine unmittelbar benachbarte Anordnung der Detektionsbereiche erreicht werden, wenn die Elektroden benachbarter Sensoren durch eine kapazitiv praktisch indifferente Trennschicht voneinander isoliert angeordnet sind. Die durch die Trennschicht getrennten Detektionsbereiche sind dann unmittelbar benachbart, so dass der Übergangsbereich mit der Trennschicht (oder einer Trennfuge) nur einen geringen bis vernachlässigbaren oder gar nicht vorhandenen Einfluss auf die Empfindlichkeit bzw. auf die Detektionsfähigkeit hat. Die Elektroden benachbarter Sensoren sind dabei gegeneinander - durch die Trennschicht - isoliert. Dadurch sind die Elektroden praktisch beliebig nahe aneinander anzugrenzen und anzuordnen. Dazu ist vorzugsweise die Trennschicht sehr dünn in Bezug auf die Dimension der betreffenden Elektroden. Sie ist aber noch so dick, dass unter Berücksichtigung des verwendeten Trennmaterials immer noch eine ausreichende Isolierung der getrennten Elektroden gegeben ist. Da die Trennschicht im Wesentlichen zwischen den benachbarten Elektroden und damit grundsätzlich eher außerhalb des Detektionsbereiches, in dem eine kapazitiv wirksame Veränderung messbar ist, angeordnet ist, ist selbst bei kleinstem Abstand (bei sehr dünner Trennschicht) der prinzipiell kapazitätserhöhende Einfluss von geringen Abständen zwischen den "Platten" hier nicht oder nur sehr eingeschränkt wirksam. Dadurch ist auch bei sehr dünner Ausführung der Trennschicht keine störende Beeinflussung der resultierenden Kapazität zwischen benachbarten Sensoren gegeben.

Das Material der Trennschicht ist elektrisch isolierend. Gemäß der Erfindung ist das Material ein Material mit einer Dielektrizitätszahl, die möglichst nahe an der Dielektrizitätszahl von Luft bzw. Vakuum ist.

Eine Doppelfunktion eines Sensors bzw. einer Elektrode bei gleichzeitiger Kosten- und Materialeinsparung sowie hoher Effizienz der Sensoranordnung wird dadurch erreicht, dass benachbarte Sensoren jeweils zumindest eine gemeinsame Elektrode und insbesondere jeweils eine weitere Elektrode aufweisen. Dann grenzen die Detektionsbereiche der Sensoren im Bereich der gemeinsamen Elektrode schon durch die geometrische Anordnung unmittelbar aneinander an oder überschneiden sich. Eine gemeinsame Elektrode kann dabei eine gemeinsame Sendeelektrode für zwei Sensoren, eine gemeinsame Empfangselektrode für zwei Sensoren und/oder eine Elektrode sein, die eine Empfangselektrode für einen Sensor und eine Sendeelektrode für einen anderen Sensor darstellt. In einem Extremfall kann - etwa wenn ein Sensor lediglich eine Elektrode zur Ermittlung der Kapazität aufweist - eine Elektrode die Empfangs- und Sendeelektrode für zwei Sensoren simultan darstellen.

Dadurch erfüllt zumindest eine Elektrode eine Doppelfunktion für zumindest zwei Sensoren, wodurch sich jeweils einerseits eine hohe Synergie in Form einer Kosten- und Materialersparnis und andererseits eine automatische, enge Eingrenzung bzw. eine automatische Überschneidung der Detektionsbereiche auf natürliche Weise ergibt. Dabei kann das Messverfahren bzw. das Meßprinzip des kapazitiven Sensors beibehalten werden und unverändert auch für den gemeinsam genutzten Sensor implementiert werden. Die Zugehörigkeit der betreffenden, gemeinsam genutzten Elektrode zu einem Sensor ist im Wesentlichen für die Detektionseigenschaften nicht oder nur eingeschränkt relevant; ein Körper oder Objekt, der/das in den überwachten Bereich einer solchen, gemeinsam genutzten Elektrode eindringt, wird detektiert. Lediglich wenn etwa eine räumliche bzw. örtliche Positionsbestimmung vorgesehen ist, kann es erforderlich sein, dass die gemeinsam genutzte Elektrode für jeden der zugehörigen Sensoren mit einem differenzierenden Messverfahren verwendet wird. So kann beispielsweise für benachbarte Sensoren - auch unabhängig von einer gemeinsamen genutzten Elektrode - mit zeitlicher Verschiebung, insbesondere sequenziell, gemessen oder mit unterschiedlicher Frequenz gemessen werden.

Die Freiheitsgrade bzw. Konfigurationsmöglichkeiten von benachbarten Sensoren können auch bei einer sehr vorteilhaften, kompakten Anordnung erhalten oder sogar verbessert werden, wenn jeder der Sensoren jeweils zumindest ein Elektrodenpaar aufweist und die Elektrodenpaare benachbarter Sensoren sich zumindest teilweise überdeckend bis verschachtelt angeordnet sind. Durch die Überdeckung bis Verschachtelung der Elektrodenpaare können diese - vorzugsweise in einer Richtung oder Hauptrichtung der Sicherheitsgeometrie - sich überschneidende Detektionsbereiche bei einer - ebenfalls vorzugsweise in einer Richtung oder Hauptrichtung der Sicherheitsgeometrie - kompakten, platzsparenden und insbesondere gestauchten Anordnung. Eine verschachtelte Anordnung kann insbesondere dadurch erreicht werden, dass eine Elektrode eines Elektrodenpaares eines Sensors zwischen den Elektroden des Elektrodenpaares des dazu benachbarten Sensors angeordnet ist. In diesem Sinne sind auch mehrfache Verschachtelungen umsetzbar.

Eine teilweise bis vollständig überdeckende Anordnung der Elektrodenpaare kann dadurch realisiert sein, dass einzelne Elektroden oder Elektrodenteile benachbarter Elektrodenpaare sich derart überdecken, dass die Erfassungsbereiche der sich überdeckenden Elektroden überlappen, so dass durch die Überdeckung oder Teilüberdeckung sich überschneidende Detektionsbereiche der benachbarten Sensoren ausgebildet werden.

Durch die Erfindung ist eine Vielzahl von Sicherheitsgeometrien sicher überwachbar, wobei im Hinblick auf die Form und/oder die Dimension und/oder die Abmessungen der betreffenden Sicherheitsgeometrie praktisch keine Einschränkungen bestehen. Bevorzugt ist eine im wesentlichen lineare Sicherheitsgeometrie vorgesehen; dabei wird automatisch eine gute Anpassung des zusammenhängenden Überwachungsbereiches an die Sicherheitsgeometrie dadurch erreicht, dass benachbarte Sensoren linear sequenziell entlang der Sicherheitsgeometrie - also im Wesentlichen entlang dem linearen Verlauf der linearen Sicherheitsgeometrie - angeordnet sind. Dann kann eine lineare Abfolge der Sensoren in Richtung der linearen Sicherheitsgeometrie vorhanden sein.

Es kann auch eine im wesentlichen flächige Sicherheitsgeometrie erfindungsgemäß sicher überwacht werden, wenn benachbarte Sensoren sequenziell entlang zumindest einer lokalen Flächenrichtung (bei einer lokal geraden/ebenen Fläche etwa eine Richtung innerhalb der Ebene, bei einer lokal gekrümmten Fläche etwa eine lokal tangentiale Richtung an der gekrümmten Fläche) insbesondere aber sequenziell jeweils entlang zweier, lokaler Flächenrichtungen (siehe oben) mit zueinander orthogonaler Komponente innerhalb der Sicherheitsgeometrie aufeinanderfolgend angeordnet sind. Bei einer Anordnung gemäß der letztgenannten Ausführung mit zwei lokalen Flächenrichtungen ergibt sich im Wesentlichen eine gitterförmige Abdeckung des betreffenden Flächenbereiches der Sicherheitsgeometrie mit linear aufeinanderfolgend angeordneten, erfindungsgemäßen Sensoren.

Die Erfindung bietet die Möglichkeit, das Sensorsystem so auszulegen, dass typischerweise erwartete, zu detektierende Körper oder Objekte mit zu erwartenden Eigenschaften oder mit zu erwartenden Eigenschaftsbereichen (etwa Abmessungsbereiche, typische physikalisch/chemische Zusammensetzungsbereiche und/oder typische Formen oder Formenbereiche) besonders zuverlässig, genau und/oder sicher und mit hoher Sensitivität und Spezifität detektiert werden. Dazu wird vorgeschlagen, dass ausgewählte Eigenschaften des Sensorsystems an eine typische Ausdehnung (Dimension oder Ausdehnung in einer oder mehreren Richtungen) und/oder (geometrische) Form und/oder (chemische oder physikalische) Zusammensetzung eines typisierten und/oder standardisierten, zu detektierenden Körpers oder Objekts angeglichen sind. So kann etwa die resultierende, wirksame Ausdehnung eines Sensors und/oder die wirksame, resultierende Ausdehnung einer Elektrode und/oder der resultierende Abstand der Elektroden eines Sensors derart angepasst oder ausgewählt sein. Mit der resultierenden, wirksamen Ausdehnung eines Sensors variiert der abgedeckte Detektionsbereich; bei größerer Ausdehnung des Sensors vergrößern sich tendenziell auch die Detektionsbereiche, und zwar sowohl in Richtung der wirksamen Sensorfläche als auch im Wesentlichen orthogonal dazu die in den überwachten Raum über der Sensorfläche ausgreifenden, elektrischen Feldbereiche (bzw. Feldlinien). Durch die diesbezügliche Angleichung an den zu detektierenden Körper oder das zu detektierende Objekt wird also tendenziell der Abstand von einer Sensoroberfläche, in dem der Körper oder das Objekt detektierbar ist, an das Objekt angepasst. Es kann auch die Ausdehnung des Detektionsbereiches eines Sensors in Richtung der wirksamen Sensorfläche angepasst werden. Mit dieser Anpassung kann eine Optimierung des Signals bzw. der Empfindlichkeit eines Sensors erreicht werden, indem die Größenordnung der Ausdehnung des Sensors an Größenordnungen des zu detektierenden Körpers oder des zu detektierenden Objektes angepasst wird. Dann ist stets gewährleistet, dass ein Körper/Objekt einen signifikanten Teilbereich des betreffenden Detektionsbereiches einnimmt und somit ein entsprechend starkes Signal generiert (in Analogie zu dem Modell, dass die "Anzahl" der durch den Körper/das Objekt verlaufenden Feldlinien etwa proportional zu dem generierten Signal bzw. zu der Signalstärke ist). Auch die Homogenität des Detektionsbereiches wird tendenziell bei Erhöhung der resultierenden, wirksamen Ausdehnung eines Sensors erhöht.

Das in dem obigen Absatz Genannte gilt für die resultierende, wirksame Ausdehnung einer Elektrode und/oder für den resultierenden Abstand der Elektroden sinngemäß und entsprechend, mit der Maßgabe, dass mit der wirksamen Ausdehnung eine Elektrode selber in besonderem Maße auch die Homogenität des Detektionsbereiches variiert werden kann.

Dabei sind die oben genannten Ausdehnungen im Bereich der Größenordnungen eines solchen standardisierten und/oder typisierten Körpers oder Objekts, insbesondere betragen sie etwa 50%, 100% oder 150 % oder jeden dazwischenliegenden Wert einer solchen typisierten und/oder standardisierten Dimension. Zu Vereinfachungszwecken kann dabei auch für räumliche Körper/Objekte auf ein einziges, im Wesentlichen repräsentatives Maß abgestellt werden. Ein solches, repräsentatives Maß ist vorzugsweise bezogen auf entsprechende Abmessungen/Dimensionen eines solchen Körpers oder Objektes in einer Richtung oder Hauptrichtung der relevanten Sicherheitsgeometrie gesehen. Insbesondere ist ein sinnvoller Bereich etwa ein Prozent bis 1.000 %, weiter insbesondere 5% bis 200%, weiter insbesondere 10% bis 50% einer standardisierten und/oder typisierten Abmessung eines solchen Körpers oder Objektes.

In einer alternativen Ausgestaltung kann durch eine entsprechende Anpassung auch bewirkt werden, dass bestimmte Körper oder Objekte gerade nicht erfasst oder sogar gezielt vernachlässigt bis ausgeblendet werden können.

Eine hohe Flexibilität der Erfindung wird dadurch gewährleistet, dass benachbarte Sensoren separat angesteuert und/oder auszuwerten sind. Das bedeutet, dass jeder Sensor oder Gruppen von Sensoren separat bestromt, aktiviert, gesteuert und/oder abgetastet und/oder ausgewertet wird. Besonders vorteilhaft kann die Spezifität der Messung erhöht werden, wenn die Lage der Sensoren in Bezug auf die Sicherheitsgeometrie vorbestimmt und vorzugsweise etwa in einer Steuerung in einer Lagetabelle abgespeichert und abrufbar ist. Dann kann eine Anwesenheit und/oder eine Sicherheitsrelevanz und/oder eine Position des Körpers oder Objekts in Bezug auf die Sicherheitsgeometrie bestimmt werden. Bei erfindungsgemäß bereitgestellter, guter Empfindlichkeit kann auch zur Verbesserung der Positionsauflösung eine zeitliche oder räumliche Interpolation eines zeitlichen oder räumlichen Signalverlaufs eines Sensors erfolgen. Dann können Zuverlässigkeit und Genauigkeit der Positionsbestimmung mit Interpolationswerten gegenüber der lediglich diskreten (digitalen) Ortsauflösung der Einzelsensoren nochmals deutlich verbessert werden.

Die erfindungsgemäßen Vorteile eines einfachen und natürlich inhärent sicherheitsgerichteten Aufbaus kommen besonders zum Tragen, wenn eine sicherheitsgerichtete Überwachung vorgesehen ist. Dazu kann eine Ansteuerung des Sensorsystems vorhanden sein, welche für die Überwachung der Sicherheitsgeometrie elektrisch/elektronisch/elektronisch programmierbar zwei- oder mehrkanalig ausgelegt ist. Insbesondere ist ein solches Sensorsystem entlang der gesamten Ansteuerkette zwei- oder mehrkanalig ausgelegt. Insbesondere ist die Sensoransteuerung für jeden Kanal auf einer dedizierten, separaten Ansteuerkarte implementiert. Gleiches gilt entsprechend für die Sensorauswertung und/oder für die Kommunikation zwischen Sensoren und Ansteuerung und/oder für Datenverarbeitung der Sensorergebnisse in einer elektrischen Steuerung. Die Erfindung bietet eine inhärente Zweikanaligkeit oder Mehrkanaligkeit bei einfacher, beispielsweise verschachtelter Sensoranordnung mit stark verringertem, apparativen und/oder konstruktiven Aufwand.

Insbesondere ist vorgesehen, dass die Sicherheitsgeometrie mittels redundanter Anordnungen von Sensoren gemäß der Erfindung und/oder mittels redundanter Überdeckung oder Verschachtelung von Sensoren gemäß Anspruch 4 zwei- oder mehrkanalig überwachbar ist.

Die oben genannten Aufgaben werden - teilweise oder vollständig - gelöst durch ein Tor oder Fenster oder eine Tür gemäß Anspruch 10. Dabei ist die Schließkante eines Schließflügels mit einem Sensorsystem nach einem der Ansprüche 1-9 überwacht und die Schließkante entspricht im Wesentlichen der Sicherheitsgeometrie gemäß der Erfindung. Dadurch werden alle oben genannten Ausführungen realisiert und alle Vorteile entsprechend erreicht.

Eine robuste, haltbare und sichere Ausführung ist dadurch gegeben, dass das Sensorsystem im Wesentlichen im Inneren eines flexiblen, praktisch kapazitiv indifferenten oder sogar alternativ kapazitiv besonders wirksamen, Schließkanten-Abschlussprofils eingebettet ist, wobei insbesondere der Überwachungsbereich der Sensoren sich über eine Höhe des Schließkanten-Abschlussprofils (im Wesentlichen orthogonal zu einer resultierenden Sensoroberfläche) hinaus erstreckt. Dadurch kann gewährleistet werden, dass eine Erfassung bzw. Detektion eines Körpers oder Objekts stattfindet, bevor eine Berührung mit der Oberfläche des Schließkanten-Abschlussprofils erfolgt.

Die Erfindung wird anhand von Ausführungsbeispielen und Zeichnungen grob schematisch erläutert. In den Zeichnungen sind gleiche oder funktionsgleiche Merkmale mit denselben Bezugszeichen versehen, sofern nichts anderes in der Beschreibung angegeben ist. Die in einer Figur gezeigten, technischen Ausgestaltungsmerkmale sind auf jede Variante der Erfindung anwendbar, und zwar auch unabhängig von anderen, in dieser Figur etwa enthaltenen und/oder beschriebenen Merkmalen, sofern zu dieser Figur bzw. diesem Ausgestaltungsmerkmal nichts anderes explizit ausgeführt ist. Es zeigen:
Figur 1 ein Orientierungsbeispiel einer Sensoranordnung aus dem Stand der Technik mit lediglich einem langgestreckten Sensor mit zwei Elektroden,
Figur 2 eine lineare Sicherheitsgeometrie mit einer erfindungsgemäßen Sensoranordnung, wobei Sensoren gemeinsame Elektroden teilen,
Figur 3 eine lineare Sicherheitsgeometrie mit einem erfindungsgemäßen Sensorsystem, wobei Elektrodenpaare benachbarter Sensoren verschachtelt angeordnet sind,
Figur 4 ein Tor mit Antrieb und einer erfindungsgemäßen Anordnung eines Sensorsystems.

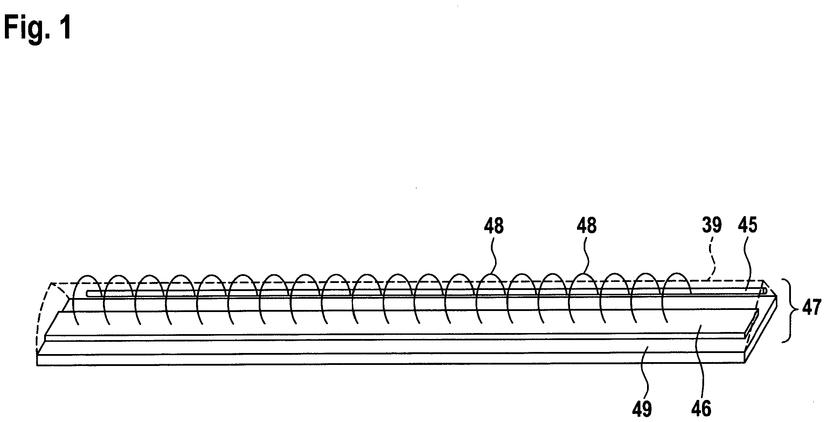

Zum besseren Verständnis und zur Orientierung zeigt die Figur 1 einen Sensor 47, der eine Elektrode 45 und eine Elektrode 46 aufweist. Sensor 47 und Elektroden 45,46 sind dabei linear langgestreckt und gerade ausgebildet. Die drahtförmige Elektrode 45 ist oberhalb der flächigen Elektrode 46 angeordnet, wobei die flächige Elektrode 46 auf einen Träger 49 aufgebracht ist. Es bilden sich Feldlinien 48 aus, die grob schematisch, nicht maßstabsgetreu und auch nicht geometrisch/elektrisch korrekt wiedergegeben sind. Diese dienen lediglich der groben Veranschaulichung des Prinzips. Dringt ein Körper oder Objekt in den durch die Feldlinien 48 überdeckten Raumbereich ein, wird der Feldverlauf - insbesondere durch die resultierende Kapazitätsänderung zwischen den Elektroden 45,46 - verändert und dadurch der Körper/das Objekt detektiert. Der Abstand der Elektroden 45,46 ist hier im Wesentlichen auf die Breite des Aufbaus begrenzt. Dadurch ist auch die Reichweite (symbolisiert durch die Feldlinien) entsprechend limitiert.

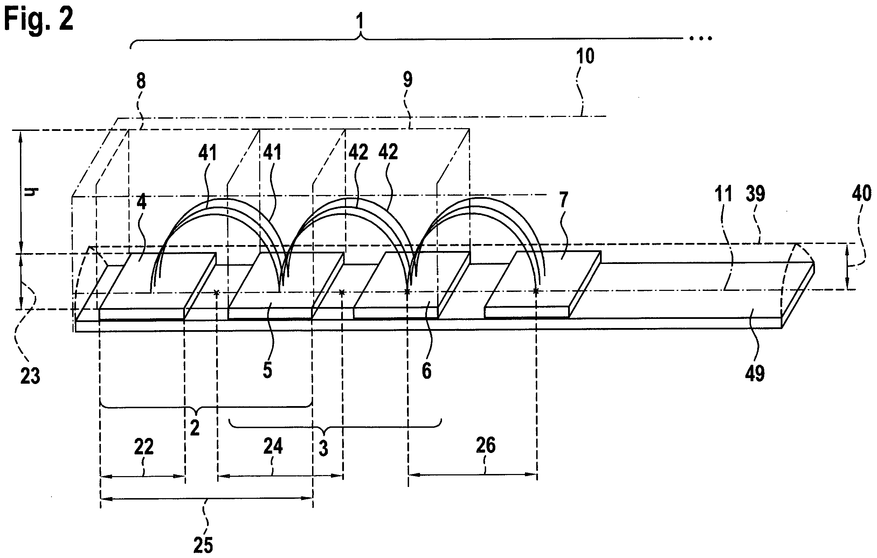

Bezugnehmend auf Figur 2 ist ein erfindungsgemäßes Sensorsystem 1 dargestellt. Das Sensorsystem 1 hat zwei kapazitive Sensoren 2,3. Der Sensor 2 beinhaltet die Sensorelektroden 4,5; der Sensor 3 umfasst die Elektroden 5,6. Zusätzlich ist noch eine Elektrode 7 rechts der Elektrode 6 gezeigt, die zu einem weiteren Sensor (nicht gekennzeichnet) gehört; diese Elektrode 7 kann (darauf wird weiter unten noch näher eingegangen) auch zu dem Sensor 3 zugehörig ausgelegt sein. Die Sensorelektroden 4,5,6,7 sind zur kapazitiven Umfeldmessung eingerichtet. Sie sind auf einem Träger 49 aufgebracht. Zusätzlich sind veranschaulichend die exemplarischen Feldlinien 41,42 gezeigt. Dringt beispielsweise ein Körper oder Objekt, der/das kapazitiv wirksam ist, in den Bereich der Feldlinien 41 des Sensors 2 ein, beeinflusst er das elektrische Feld (die Feldlinien 41), wodurch sich eine kapazitive Rückwirkung auf den Sensor 2 mittels der Elektroden 4,5 ergibt, die messbar ist. Des Weiteren ist gezeigt, dass jeder Sensor 2,3 einen zugehörigen Detektionsbereich 8,9 aufweist. Exemplarisch an dem Sensor 2 dargestellt ist der Detektionsbereich 8 ein im Wesentlichen zylindrisch in Längsrichtung fortgesetztes Rechteck; es ergibt sich etwa ein schlauchförmiger bzw. zylindrischer Verlauf mit rechteckförmigem Querschnitt. Dabei ist vereinfachend angenommen, dass die Höhe h des Detektionsbereiches 8 praktisch der Höhe der Feldlinien 41 über der Oberfläche der Elektroden 4,5 entspricht. Dies dient lediglich der Veranschaulichung. Die Höhe h kann auch größer oder kleiner sein als die der exemplarisch gezeigten Feldlinien 41. Die hier dargestellte Geometrie ist lediglich aus Gründen der Einfachheit und Veranschaulichung rechteckförmig gewählt. Ein realer Verlauf der Detektionsbereiche hat eher eine in Längsrichtung wellenförmiger Kontur und ist nicht streng rechteckförmig.

Zusammengenommen ergeben die Detektionsbereiche 8,9 der Sensoren 2,3 einen resultierenden Überwachungsbereich 10. Die Detektionsbereiche 8,9 der benachbarten Sensoren 2,3 überschneiden sich lokal (nämlich im Wesentlichen oberhalb der Oberfläche der Elektrode 5). Durch die Überschneidung der Detektionsbereiche 8,9 ist offenbar, dass der resultierende Überwachungsbereich 10, der aus der Vereinigungsmenge der beiden Detektionsräume bzw. Detektionsbereiche 8,9 (und ggf. weiterer, nicht explizit angegebener Detektionsbereiche weiterer Sensoren) besteht, zusammenhängend - also insbesondere in Längsrichtung lückenlos - ist. Das gesamte Sensorsystem 1 ist hier im Zusammenhang mit einer im Wesentlichen linearen Sicherheitsgeometrie 11 gezeigt. Die Sicherheitsgeometrie 11 ist hier lediglich schematisch durch eine strichpunktierte Linie angedeutet. Die Sicherheitsgeometrie 11 kann in der gezeigten, geraden Längsrichtung verlaufen und sich auch orthogonal dazu in Flächenrichtung der Oberfläche der Elektroden 4,5,6,7 und/oder orthogonal in Richtung der Höhe h der Detektionsbereiche 8,9 erstrecken. Der zusammenhängende Überwachungsbereich 10 bildet in diesem Fall die überwachte, vorbestimmte Sicherheitsgeometrie 11, indem er die vorbestimmte Sicherheitsgeometrie 11 praktisch vollständig abdeckt.

Die Überschneidung der Detektionsbereiche 8,9 der Sensoren 2,3 wird in der Ausgestaltung der Figur 2 dadurch erreicht, dass die Sensoren 2,3 sich die Elektrode 5 teilen. Der Sensor 2 weist dabei zusätzlich noch die weitere Elektrode 4 und der Sensor 3 zusätzlich die Elektrode 6 auf. Die Detektionsbereiche 8,9 überschneiden sich somit im Bereich der gemeinsam genutzten Elektrode 5. Das Feld des Sensors 2 bildet sich damit zwischen den Elektroden 4,5 (symbolisiert durch die Feldlinien 41) aus. Das Feld des Sensors 3 bildet sich zwischen den Elektroden 5,6 (symbolisiert durch die Feldlinien 42) aus. Die Feldlinien 41,42 sind lediglich exemplarisch dargestellt; es ist offensichtlich, dass aufgrund der endlichen Ausdehnungen der Elektroden 4,5,6,7 in Richtung der Sicherheitsgeometrie 11 und orthogonal dazu in der anderen Flächenrichtung der Elektroden 4,5,6,7 sich auch das Feld mit entsprechend breiter und langer Startfläche der Feldlinien 41,42 im Bereich der gesamten Oberfläche der Elektroden 4,5,6,7 ausbildet. Dadurch ist offensichtlich, dass sich die Felder wie oben ausgeführt auch großräumig überschneiden und sich nicht nur etwa - wie durch die Feldlinien 41,42 schematisch angedeutet - lediglich berühren.

Die Sicherheitsgeometrie 11 ist linear und die benachbarten Sensoren 2,3 sind linear sequenziell entlang der Längsrichtung der Sicherheitsgeometrie 11 angeordnet. Bezogen auf den Sensor 2 beträgt die resultierende, wirksame Ausdehnung 25 dieses Sensors die in der Figur 2 dargestellte Strecke, die vom linksseitigen Ende (bzw. der entsprechenden Kante) der Elektrode 4 in Längsrichtung bis in Längsrichtung zum rechtsseitigen Ende der Elektrode 5 reicht. Der resultierende Abstand 26 aller Elektroden 4,5,6,7 der Figur 2 ist hier mit etwa gleicher Größe dargestellt. Er reicht etwa von einer Flächenmitte einer Elektrode 6 bis zur Flächenmitte der nächsten Elektrode 7 in Längsrichtung nach rechts gesehen. Die resultierende, wirksame Ausdehnung 22 der Elektroden 4,5,6,7 ist ebenfalls in der Figur 2 für alle gleich und exemplarisch an der Elektrode 4 dargestellt. Die Ausdehnungen 22,25,26 sind jeweils einzeln oder in beliebiger Kombination an eine typische Ausdehnung und/oder Form und/oder Zusammensetzung eines typischen, zu detektierenden Körpers oder Objekts (nicht gezeigt) angeglichen. Ein Körper/Objekt hätte dann etwa die Größenordnung einer dieser Abmessungen oder eine Größenordnung, die mit ausgewählten, einzelnen bis allen Abmessungen 22,25,26 korrespondiert. Die Sensoren 2,3 sind (nicht gezeigt) separat angesteuert und separat auszuwerten. Die Lage der Sensoren 2,3 ist insbesondere in Bezug auf die Sicherheitsgeometrie fest und vorbestimmt; sie ist zur Auswertung der Anwesenheit eines Körpers oder Objekts über einem bestimmten Sensor 2,3 und/oder für eine Sicherheitsrelevanz und/oder eine Position des Körpers oder Objekts in Bezug auf die Sicherheitsgeometrie 11 verwendbar.

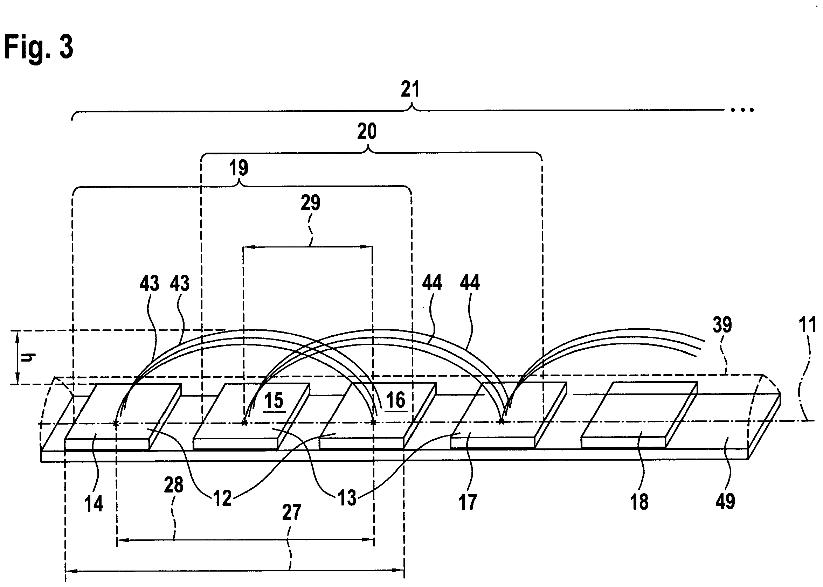

Figur 3 zeigt ein alternatives Sensorsystem 1. Es hat die Sensoren 12,13, die jeweils Elektroden 14,15 bzw. Elektroden 16,17 aufweisen. Zur Fortsetzung ist noch lediglich der Vollständigkeit halber eine rechts außen angeordnete Elektrode 18 dargestellt. Auch diese Elektroden 14,15,16,17,18 sind auf einem Träger 49 angeordnet. Jeder der Sensoren 12,13 hat jeweils ein zugeordnetes Elektrodenpaar 14,16;15,17. Die Elektrodenpaare 14,16;15,17 der benachbarten Sensoren 12;13 sind verschachtelt angeordnet. Dazu sind die Elektroden 14,16 des Sensors 12 um mehr als eine Breite einer Elektrode 14,15,16,17,18 in Längsrichtung der Sicherheitsgeometrie 11 voneinander mit ihren zueinander gerichteten Kanten entfernt angeordnet, so dass zwischen den Elektroden 14,16 noch eine Elektrode 15 des benachbarten Sensors 13 angeordnet werden kann. Das gleiche gilt sinngemäß für die Elektrode 16 des Sensors 12, die zwischen den Elektroden 15,17 des Sensors 13 positioniert ist. Dadurch wird der resultierende Elektrodenabstand 28 beispielsweise der Elektroden 14,16 des Sensors 12 entsprechend vergrößert, so dass die exemplarisch gezeigten Feldlinien 43,44 (die das entsprechende, elektrische Feld repräsentieren) eine größere Ausdehnung in Richtung der Sicherheitsgeometrie 11 aufweisen; gleichzeitig ist auch die Höhe h der Feldlinien 43,44 vergrößert, sodass die Reichweite orthogonal zu der Oberfläche der Elektroden 14,15,16,17,18 bei größerem Elektrodenabstand erhöht ist. Für den resultierenden Sensorabstand 29, die wirksame Sensorlänge 20 sowie für die Länge 22 und die Breite 23 der Elektroden gilt das zu der Figur 2 oben Ausgeführte sinngemäß und entsprechend.

Durch die verschachtelte oder verschränkte Anordnung der Elektrodenpaare 14,16;15,17 der Sensoren 12,13 überschneiden sich die Detektionsbereiche 19 des Sensors 12 und 20 des Sensors 13 in hohem Maße. Die Überschneidung ist so weitgehend, dass in Längsrichtung der Sicherheitsgeometrie 11 gesehen jeder Punkt Innerhalb der Höhe h praktisch von mindestens zwei Detektionsbereichen 19,20 gleichzeitig überwacht ist. Der entsprechende Überwachungsbereich 21 ist somit allein durch die gezielte Anordnung automatisch redundant bzw. zweikanalig überwacht. Gegenüber der Ausgestaltung der Fig. 2 hat der (real eher wellenförmige, s.o.) Verlauf in dem Beispiel der Fig. 3 aufgrund des höheren Basisabstandes wegen der Verschachtelung eine homogenere Kontur, da die lokale Krümmung der Feldlinien an der Oberseite aufgrund der größeren Abstände weniger stark ist.

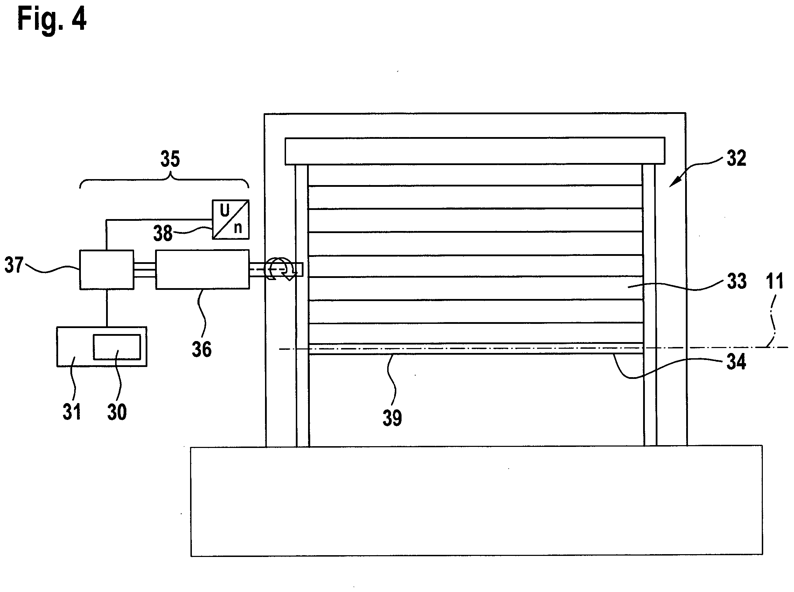

Schließlich zeigt die Figur 4 eine grob schematische Draufsicht mit einer symbolischen Steuer- und Antriebsanordnung 35 für ein Tor 32, welches mit einem Sensorsystem 1 gemäß der vorliegenden Erfindung ausgestattet ist. Das Tor 32 hat einen nach oben und nach unten verfahrenden und dadurch öffenbaren und schließbaren Schließflügel 33. Die Unterseite des Schließflügels 33, mit der der Schließflügel 33 geschlossen werden kann, ist eine Schließkante 34. Symbolisch gezeigt ist ein Antriebsaggregat 35 mit einem Elektromotor 36, der über einen Wechselrichter 37 mit Leistung versorgt wird. Zusätzlich ist ein Positionsgeber 38 vorgesehen, der die Position der Achse des Elektromotors 36 und damit die Stellung des Schließflügels 33 zwischen einer voll geöffneten (nicht gezeigt) und einer voll geschlossenen (nicht gezeigt) Stellung angibt. Des Weiteren ist eine Ansteuerung 30 des erfindungsgemäßen Sensorsystems 1 sowie eine elektrische Steuerung 31 gezeigt, mittels derer das Tor 32 gesteuert und die Verstellung sowie das Sensorsystem 1 überwacht werden kann. Das Tor 32 ist insgesamt mit einem Sensorsystem 1 nach einem der Ansprüche 1-9 überwacht; die Schließkante 34 entspricht im Wesentlichen in ihrem Verlauf der Sicherheitsgeometrie 11. Lediglich schematisch angedeutet ist ein Schließkanten-Abschlussprofil 39. Dieses ist auch in den Figuren 2 und 3 dargestellt. Das Schließkanten-Abschlussprofil 39 hat eine Höhe 40. Der Überwachungsbereich 10 der Sensoren 2,3 (jeweils unter Bezugnahme auf die Figur 2) erstreckt sich über die Höhe 40 des Schließkanten-Abschlussprofils 39 hinausgehend.

### Bezugszeichenliste

- 1: Sensorsystem
- 2: Sensor
- 3: Sensor
- 4: Elektrode
- 5: Elektrode
- 6: Elektrode
- 7: Elektrode
- 8: Detektionsbereich
- 9: Detektionsbereich
- 10: Überwachungsbereich
- 11: Sicherheitsgeometrie
- 12: Sensor
- 13: Sensor
- 14: Elektrode
- 15: Elektrode
- 16: Elektrode
- 17: Elektrode
- 18: Elektrode
- 19: Detektionsbereich
- 20: Detektionsbereich
- 21: Überwachungsbereich
- 22: Länge der Elektrode
- 23: Breite der Elektrode
- 24: resultierender Sensorabstand
- 25: wirksame Sensorlänge
- 26: Elektrodenabstand
- 27: wirksame Sensorlänge
- 28: Elektrodenabstand
- 29: resultierender Sensorabstand
- 30: Ansteuerung
- 31: elektrische Steuerung
- 32: Tor
- 33: Schließflügel
- 34: Schließkante
- 35: Antriebsaggregat
- 36: Elektromotor
- 37: Wechselrichter
- 38: Positionsgeber
- 39: Schließkanten-Abschlussprofil
- 40: Höhe des Abschlussprofils
- 41: Feldlinie
- 42: Feldlinie
- 43: Feldlinie
- 44: Feldlinie
- 45: Elektrode
- 46: Elektrode
- 47: Sensor
- 48: Feldlinien
- 49: Träger
- h: Höhe

## Patentansprüche

1. Sensorsystem (1) zur Umfeldüberwachung, mit mindestens zwei kapazitiven Sensoren (2,3,12,13), die jeweils ein Elektrodenpaar (4,5,6,7,14,16,15,17) aufweisen, die zur kapazitiven Umfeldmessung eingerichtet ist, wobei jeder Sensor (2,3) einen Detektionsbereich (8,9) aufweist, innerhalb dessen eine kapazitiv wirksame Veränderung des Umfeldes, insbesondere durch Annäherung und/oder Kontakt eines Körpers oder eines Objektes, detektierbar ist, und die Detektionsbereiche (8,9) der mindestens zwei Sensoren (2,3) einen resultierenden Überwachungsbereich (10) bilden, wobei die Detektionsbereiche (8,9) benachbarter Sensoren (2,3) sich lokal überschneiden und/oder unmittelbar benachbart sind, so dass deren resultierender Überwachungsbereich (10) zusammenhängend ist und der zusammenhängende Überwachungsbereich (10) zumindest einen Teil einer - insbesondere vollständig - überwachten, vorbestimmten Sicherheitsgeometrie (11) bildet, **dadurch gekennzeichnet, dass** die Elektroden benachbarter Sensoren (2,3,12,13) durch eine kapazitiv indifferente Trennschicht voneinander isoliert angeordnet sind, so dass die entlang der Trennschicht benachbarten Sensoren unmittelbar benachbarte Detektionsbereiche aufweisen und das Material der Trennschicht ein Material mit einer Dielektrizitätszahl nahe an der Dielektrizitätszahl von Luft oder Vakuum ist, wobei die Elektrodenpaare (14,16;15,17) benachbarter Sensoren (12,13) sich zumindest teilweise überdeckend bis verschachtelt angeordnet sind.

2. Sensorsystem nach Anspruch 1, **dadurch gekennzeichnet, dass** benachbarte Sensoren (2,3) jeweils eine gemeinsame Elektrode (5), so dass die Detektionsbereiche (8,9) der Sensoren (2,3) im Bereich der gemeinsamen Elektrode (5) unmittelbar aneinander angrenzen bis sich überschneiden.

3. Sensorsystem nach Anspruch 1 oder 2, **dadurch gekennzeichnet, dass** eine im wesentlichen lineare Sicherheitsgeometrie (11) vorgesehen ist, wobei benachbarte Sensoren (2,3;12,13) linear sequentiell entlang der Sicherheitsgeometrie (11) angeordnet sind oder dass eine im wesentlichen flächige Sicherheitsgeometrie vorgesehen ist, wobei benachbarte Sensoren sequentiell entlang zumindest einer lokalen Flächenrichtung, insbesondere sequentiell jeweils entlang zweier, lokaler Flächenrichtungen mit zueinander orthogonaler Komponente innerhalb der Sicherheitsgeometrie aufeinanderfolgend angeordnet sind.

4. Sensorsystem nach einem der Ansprüche 1 bis 3, **dadurch gekennzeichnet, dass** die resultierende, wirksame Ausdehnung (25;27) eines Sensors (2;12) und/oder die resultierende, wirksame Ausdehnung (22,23) einer Elektrode (4) und/oder der resultierende Abstand (26;28) der Elektroden (14,16;15,17) eines Sensors (12;13) an eine typische Ausdehnung und/oder Form und/oder Zusammensetzung eines typisierten und/oder standardisierten, zu detektierenden Körpers oder Objekts angeglichen sind/ist, insbesondere etwa 1% bis 1.000%, weiter insbesondere 5% bis 200%, weiter insbesondere 10% bis 50% einer standardisierten und/oder typisierten Abmessung eines solchen Körpers oder Objektes betragen/beträgt.

5. Sensorsystem nach einem der Ansprüche 1 bis 4, **dadurch gekennzeichnet, dass** benachbarte Sensoren (2,3;12,13) separat angesteuert und/oder auszuwerten sind und die Lage der Sensoren (2,3;12,13) in Bezug auf die Sicherheitsgeometrie (11) definiert ist, so dass eine Anwesenheit und/oder eine Sicherheitsrelevanz und/oder eine Position des Körpers oder Objekts in Bezug auf die Sicherheitsgeometrie bestimmbar ist.

6. Sensorsystem nach einem der Ansprüche 1 bis 5, **dadurch gekennzeichnet, dass** eine Ansteuerung (30) des Sensorsystems vorgesehen ist, welche für die Überwachung der Sicherheitsgeometrie (11) elektrisch/elektronisch/elektronisch programmierbar zwei- oder mehrkanalig, insbesondere entlang der gesamten Ansteuerkette zwei- oder mehrkanalig, ausgelegt ist, insbesondere mit zwei- oder mehrkanaliger, je Kanal mittels einer separaten Ansteuerkarte implementierter Sensoransteuerung und Sensorauswertung und/oder mit zwei- oder mehrkanaliger Kommunikation zwischen Sensoren (2,3;12,13) und Ansteuerung und/oder mit zwei- oder mehrkanaliger Datenverarbeitung der Sensorergebnisse in einer elektrischen Steuerung (31), insbesondere Maschinensteuerung.

7. Sensorsystem nach einem der Ansprüche 1 bis 6, **dadurch gekennzeichnet, dass** die Sicherheitsgeometrie (11) mittels redundanter Anordnungen von Sensoren (2,3) und/oder mittels redundanter Überdeckung oder Verschachtelung von Sensoren (12,13) gemäß Anspruch 4 zwei- oder mehrkanalig überwachbar ist.

8. Tür, Tor (32) oder Fenster, insbesondere industrielle Tür, industrielles Tor oder Fenster, insbesondere Falttor, Rolltor, Segmenttor, Schiebetor, Klapptor, Flügeltür, Drehflügeltür, Flügelfenster, Lamellenfenster oder dergleichen mit zumindest einem öffenbaren und schließbaren Schließflügel (33) mit zumindest einer Schließkante (34), einem Antrieb (35) zum Antreiben des Schließflügels (33) und einer Steuerung (31), wobei die Tür, das Tor (32) oder Fenster mit einem Sensorsystem nach einem der Ansprüche 1 bis 9 überwacht ist und die Schließkante (34) im Wesentlichen der Sicherheitsgeometrie (11) entspricht.

9. Tür, Tor oder Fenster nach Anspruch 8, **dadurch gekennzeichnet, dass** das Sensorsystem im Wesentlichen im Inneren eines flexiblen, im Wesentlichen kapazitiv indifferenten oder alternativ kapazitiv wirksamen, Schließkanten-Abschlussprofils (39) eingebettet ist, wobei insbesondere der Überwachungsbereich (10;21) der Sensoren (2,3; 12,13) sich über die Höhe (40) des Schließkanten-Abschlussprofils hinaus erstreckt.

## Claims

1. Sensor system (1) for monitoring the environment, having at least two capacitive sensors (2, 3, 12, 13) each having an electrode pair (4, 5, 6, 7, 14, 16, 15, 17) configured to capacitively measure the environment, wherein each sensor (2, 3) has a detection region (8, 9) within which a capacitively effective change in the environment, in particular as a result of the approach and/or contact of a body or an object, can be detected, and the detection regions (8, 9) of the at least two sensors (2, 3) form a resulting monitoring region (10), wherein the detection regions (8, 9) of adjacent sensors (2, 3) locally overlap and/or are directly adjacent, with the result that their resulting monitoring region (10) is contiguous and the contiguous monitoring region (10) forms at least part of an - in particular fully - monitored, predetermined safety geometry (11), **characterized in that** the electrodes of adjacent sensors (2, 3, 12, 13) are arranged such that they are isolated from one another by means of a capacitively indifferent separation layer, with the result that the sensors that are adjacent along the separation layer have directly adjacent detection regions, and the material of the separation layer is a material with a dielectric constant close to the dielectric constant of air or vacuum, wherein the electrode pairs (14, 16; 15, 17) of adjacent sensors (12, 13) are arranged so as to be at least partially overlapping through to interleaved.

2. Sensor system according to Claim 1, **characterized in that** adjacent sensors (2, 3) each have a common electrode (5), with the result that the detection regions (8, 9) of the sensors (2, 3) are directly adjacent to one another through to overlapping in the region of the common electrode (5).

3. Sensor system according to Claim 1 or 2, **characterized in that** a substantially linear safety geometry (11) is provided, wherein adjacent sensors (2, 3; 12, 13) are arranged linearly sequentially along the safety geometry (11), or **in that** a substantially two-dimensional safety geometry is provided, wherein adjacent sensors are arranged in succession sequentially along at least one local surface direction, in particular sequentially in each case along two local surface directions with a mutually orthogonal component within the safety geometry.

4. Sensor system according to one of Claims 1 to 3, **characterized in that** the resulting effective extent (25; 27) of a sensor (2; 12) and/or the resulting effective extent (22, 23) of an electrode (4) and/or the resulting distance (26; 28) between the electrodes (14, 16; 15, 17) of a sensor (12; 13) is/are adjusted to a typical extent and/or shape and/or composition of a typified and/or standardized body or object to be detected, in particular is/are approximately 1% to 1000%, more particularly 5% to 200%, more particularly 10% to 50%, of a standardized and/or typified dimension of such a body or object.

5. Sensor system according to one of Claims 1 to 4, **characterized in that** adjacent sensors (2, 3; 12, 13) are controlled and/or are to be evaluated separately and the position of the sensors (2, 3; 12, 13) with respect to the safety geometry (11) is defined, such that a presence and/or a safety relevance and/or a position of the body or object with respect to the safety geometry can be determined.

6. Sensor system according to one of Claims 1 to 5, **characterized in that** control (30) of the sensor system is provided, which, for the purpose of monitoring the safety geometry (11), is designed to be electrically/electronically/electronically programmable in two or multiple channels, in particular in two or multiple channels along the entire control chain, in particular with two-channel or multi-channel sensor control and sensor evaluation implemented for each channel by means of a separate control card and/or with two-channel or multi-channel communication between sensors (2, 3; 12, 13) and control and/or with two-channel or multi-channel data processing of the sensor results in an electrical controller (31), in particular a machine controller.

7. Sensor system according to one of Claims 1 to 6, **characterized in that** the safety geometry (11) can be monitored in two or multiple channels by means of redundant arrangements of sensors (2, 3) and/or by means of redundant overlapping or interleaving of sensors (12, 13) according to Claim 4.

8. Door, gate (32) or window, in particular industrial door, industrial gate or window, in particular folding gate, rolling gate, sectional gate, sliding gate, flap gate, folding door, swing door, casement window, louvre window or the like, having at least one openable and closable closing wing (33) with at least one closing edge (34), a drive (35) for driving the closing wing (33) and a controller (31), wherein the door, the gate (32) or window is monitored using a sensor system according to one of Claims 1 to 9, and the closing edge (34) corresponds substantially to the safety geometry (11).

9. Door, gate or window according to Claim 8, **characterized in that** the sensor system is embedded substantially in the interior of a flexible, substantially capacitively indifferent or alternatively capacitively effective closing edge terminating profile (39), wherein the monitoring region (10; 21) of the sensors (2, 3; 12, 13), in particular, extends beyond the height (40) of the closing edge terminating profile.

## Revendications

1. Système capteur (1) destiné à la surveillance de l'environnement, comprenant au moins deux capteurs capacitifs (2, 3, 12, 13), lesquels possèdent respectivement une paire d'électrodes (4, 5, 6, 7, 14, 16, 15, 17), qui sont conçues pour la mesure d'environnement capacitive, chaque capteur (2, 3) présentant une zone de détection (8, 9) à l'intérieur de laquelle peut être détectée une modification capacitivement efficace de l'environnement, notamment par l'approche et/ou le contact d'un corps ou d'un objet, et les zones de détection (8, 9) des au moins deux capteurs (2, 3) formant une zone de surveillance (10) résultante, les zones de détection (8, 9) de capteurs (2, 3) voisins se recoupant localement et/ou étant directement voisines, de sorte que leur zone de surveillance (10) résultante est cohérente et la zone de surveillance (10) cohérente forme au moins une partie d'une géométrie de sécurité (11) prédéterminée - notamment entièrement - surveillée, **caractérisé en ce que** les électrodes de capteurs (2, 3, 12, 13) voisins sont disposées isolées les unes des autres par une couche de séparation capacitivement indifférente, de sorte que les capteurs voisins le long de la couche de séparation présentent des zones de détection directement voisines et le matériau de la couche de séparation est un matériau ayant une constante diélectrique proche de la constante diélectrique de l'air ou du vide, les paires d'électrodes (14, 16 ; 15, 17) de capteurs (12, 13) voisins étant disposées au moins partiellement en recouvrement à imbriquées.

2. Système capteur selon la revendication 1, **caractérisé en ce que** les capteurs (2, 3) voisins présentent respectivement une électrode commune (5), de sorte que les zones de détection (8, 9) des capteurs (2, 3) dans la zone de l'électrode commune (5) sont directement adjacentes les unes aux autres jusqu'à se recouper.

3. Système capteur selon la revendication 1 ou 2, **caractérisé en ce qu'**une géométrie de sécurité (11) sensiblement linéaire est prévue, des capteurs (2, 3 ; 12, 13) voisins étant disposés séquentiellement linéairement le long de la géométrie de sécurité (11) ou **en ce qu'**une géométrie de sécurité sensiblement plate est prévue, des capteurs voisins étant disposés successivement séquentiellement le long d'au moins une direction de surface locale, notamment séquentiellement respectivement le long de deux directions de surface locales ayant des composantes orthogonales les unes aux autres à l'intérieur de la géométrie de sécurité.

4. Système capteur selon l'une quelconque des revendications 1 à 3, **caractérisé en ce que** l'extension (25 ; 27) efficace résultante d'un capteur (2 ; 12) et/ou l'extension (22, 23) efficace résultante d'une électrode (4) et/ou l'écart (26 ; 28) résultant des électrodes (14, 16 ; 15, 17) d'un capteur (12 ; 13) est/sont harmonisé(e)s à une extension et/ou forme et/ou composition type d'un corps ou objet standardisé et/ou normalisé à détecter, représente(nt) en particulier environ 1 % à 1 000 %, plus particulièrement 5 % à 200 %, plus particulièrement 10 % à 50 % d'une dimension standardisée et/ou normalisée d'un tel corps ou objet.

5. Système capteur selon l'une quelconque des revendications 1 à 4, **caractérisé en ce que** les capteurs (2, 3 ; 12, 13) voisins sont commandés et/ou à interpréter séparément et la position des capteurs (2, 3 ; 12, 13) par rapport à la géométrie de sécurité (11) est définie, de sorte qu'une présence et/ou une pertinence de sécurité et/ou une position du corps ou de l'objet par rapport à la géométrie de sécurité peut être déterminée.

6. Système capteur selon l'une quelconque des revendications 1 à 5, **caractérisé en ce qu'**une commande (30) du système capteur est prévue, laquelle est conçue électriquement / électroniquement / programmable électroniquement avec deux canaux ou plus, notamment avec deux canaux ou plus le long de l'ensemble de la chaîne de commande, pour la surveillance de la géométrie de sécurité (11), notamment avec une commande de capteur et une interprétation de capteur à deux canaux ou plus, chaque canal mis en œuvre au moyen d'une carte de commande séparée et/ou avec communication à deux canaux ou plus entre les capteurs (2, 3 ; 12, 13) et commande et/ou avec traitement de données à deux canaux ou plus des résultats des capteurs dans une commande électrique (31), notamment une commande de machine.

7. Système capteur selon l'une quelconque des revendications 1 à 6, **caractérisé en ce que** la géométrie de sécurité (11) peut être surveillée sur deux canaux ou plus au moyen d'arrangements redondants de capteurs (2, 3) et/ou au moyen d'un recouvrement ou d'une imbrication redondant(e) de capteurs (12, 13) selon la revendication 4.

8. Porte, portail (32) ou fenêtre, notamment porte industrielle, portail industriel ou fenêtre, notamment portail pliant, portail roulant, portail segmenté, portail coulissant, portail battant, porte à double battant, porte à double battant rotative, fenêtre à double battant, fenêtre à lamelles ou similaires, comprenant au moins un battant de fermeture (33) qui peut être ouvert et fermé, comprenant au moins un bord de fermeture (34), un mécanisme d'entraînement (35) destiné à entraîner le battant de fermeture (33) et une commande (31), la porte, le portail (32) ou la fenêtre étant surveillé(e) par un système capteur selon l'une quelconque des revendications 1 à 9 et le bord de fermeture (34) correspondant sensiblement à la géométrie de sécurité (11).

9. Porte, portail ou fenêtre selon la revendication 8, caractérisé(e) en ce que le système capteur est incorporé sensiblement à l'intérieur d'un profilé de terminaison (39) de bord de fermeture flexible, sensiblement capacitivement indifférent ou, en variante, capacitivement efficace, en particulier la zone de surveillance (10 ; 21) des capteurs (2, 3 ; 12, 13) s'étendant au-delà de la hauteur (40) du profilé de terminaison de bord de fermeture.
